# EUROPÄISCHE PATENTANMELDUNG

(11) **EP 0 930 601 A2**
(43) Veröffentlichungstag der Anmeldung: **21.07.1999**
(21) Anmeldenummer: 99250002.5
(22) Anmeldetag: 04.01.1999
(51) Int. Cl.: G09F 9/37, G09F 9/33

(54) **Verfahren zur Herstellung einer Punkt-Matrix-Anzeigeeinrichtung**

(30) Priorität: 20.01.1998 DE 19802877
(71) Anmelder: InfoSystems GmbH, Visuelle und akustische Systeme für die Verkehrstechnik, 42109 Wuppertal (DE)
(72) Erfinder: Khavand, Fariborz, 42109 Wuppertal (DE)
(74) Vertreter: Christiansen, Henning, Dipl.-Ing.

(57) **Zusammenfassung**

Verfahren zur Herstellung einer hinter einer gekrümmten Scheibe anzuordnenden Punkt-Matrix-Anzeigeeinrichtung aus Anzeige-Elementen (1), die einen Elementkörper (4) und jeweils auf dessen dem Betrachter abgewandter Seite angeordnete dünne, langgestreckte, im wesentlichen senkrecht zum von ihnen gebildeten Abschnitt (6.1) der Anzeigenoberfläche (6) verlaufende elektrische Anschlußmittel (5) aufweisen, bei dem die Anzeige-Elemente (1) auf wenigstens einer ebenen Leiterplatte (2) angeordnet werden, wobei ihre Anschlußmittel (5) durch Bohrungen (7) in der Leiterplatte (2; 2') geführt und anschließend galvanisch mit der Leiterplatte (2) verbunden werden, und wobei die Anzeige-Elemente (1; 1') zur Anpassung der Punkt-Matrix-Anzeigeeinrichtung an eine gekrümmte Scheibe derart in Richtung der Flächennormalen der Leiterplatte (2) gestuft angeordnet werden, daß wenigstens eine der Hauptkrümmungen der Scheibe nach Art einer Treppe angenähert ist, und wobei die Elementkörper (4) wenigstens während der Herstellung der galvanischen Verbindung durch Positioniermittel (11) in ihrem jeweiligen senkrechten Abstand zur Leiterplatte (2) gehalten werden.

## Beschreibung

Die Erfindung betrifft ein Verfahren gemäß dem Oberbegriff des Anspruchs 1.

Mittels derartiger Verfahren hergestellte Punkt-Matrix-Anzeigeeinrichtungen finden beispielsweise als Fahrzielanzeigen bei Bussen oder Bahnen im öffentlichen Personennahverkehr ihre Anwendung. Sie können zum einen als passive Anzeigeeinrichtungen ausgeführt sein, bei denen die Anzeige-Elemente jeweils ein zwischen zwei stabilen Drehstellungen elektromagnetisch umschaltbares Anzeigeplättchen aufweisen, in dessen erster Drehstellung dem Betrachter eine lichtreflektierende, meist gelb gefärbte Oberfläche und in dessen zweiter Drehstellung dem Betrachter eine mehr oder weniger lichtabsorbierende, meist schwarze Oberfläche zugewandt ist. Zum anderen können die Anzeige-Elemente auch als aktive Elemente, beispielsweise Leuchtdioden oder dergleichen, ausgeführt sein.

Bei bekannten Verfahren zur Herstellung derartiger Punkt-Matrix-Anzeigeeinrichtungen werden die elektrischen Anschlußmittel der Anzeige-Elemente, die in der Regel aus zwei relativ starren Anschlußdrähten bestehen, so weit durch entsprechende Bohrungen in der Leiterplatte geführt, bis der Elementkörper an die Leiterplatte anstößt. Anschließend werden die Anschlußdrähte durch Lötpunkte mit der Leiterplatte verbunden. Hierbei entsteht eine parallel zur Leiterplatte verlaufende Anzeigenoberfläche. Die Verlötung der Anschlußdrähte auf der Leiterplatte übernimmt dabei in der Regel auch den wesentlichen Anteil der mechanischen Fixierung der Anzeige-Elemente relativ zur Leiterplatte.

Die bekannten Verfahren weisen jedoch den Nachteil auf, daß die Leiterplatten nach der Montage der Anzeige-Elemente durch relativ aufwendige Maßnahmen an die Krümmung der Scheibe, hinter der die Anzeigeeinrichtung angeordnet werden soll, angepaßt werden muß. So ist beispielsweise aus der europäischen Patentschrift Nr. 0 594 367 B1 ist eine Anzeigevorrichtung bekannt, bei der die Leiterplatten mit den Anzeige-Elementen auf einem langgestreckten, quer zu seiner Längsrichtung deformierbaren Rahmen montiert werden. Zur Anpassung der Anzeigevorrichtung an eine gekrümmte Scheibe wird der deformierbare Rahmen dann über eine Vielzahl von Streben, die zwischen dem deformierbaren Rahmen und einem hinter der Scheibe zu montierenden Querträger verlaufen, gegen die Scheibe gedrückt und dabei so deformiert, daß sich der Rahmen und damit die Anzeigevorrichtung an die Scheibenkrümmung anpassen.

Ein weiterer Nachteil dieses Herstellungsverfahrens neben der Vielzahl der hierfür notwendigen Arbeitsschritte liegt in der Biegebelastung der Leiterplatten, auf denen die Punkt-Matrix-Elemente angeordnet sind. Die Leiterplatten sowie die galvanischen bzw. mechanischen Verbindungen zwischen den Punkt-Matrix-Elementen und den Leiterplatten sind nicht zuletzt in Anbetracht der bei Straßen- oder Schienenfahrzeugen häufig hohen Schwingungsbelastungen durch diese Vorspannung einem erhöhten Beschädigungs- und damit Ausfallrisiko unterworfen.

Bei anderen bekannten derartigen Herstellungsverfahren werden auf einem langgestreckten, in seiner Längsrichtung mit Knicken versehenen Rahmen jeweils zwischen den Knickstellen kurze Leiterplatten montiert, so daß die Krümmung der Scheibe nach Art eines Polygonzuges angenähert ist.

Auch diese Variante weist den Nachteil auf, daß sie relativ zeitaufwendig ist, da aufgrund der relativ großen Anzahl kurzer Leiterplatten eine Vielzahl von Montageschritten erforderlich ist.

Ein weiterer Nachteil der genannten Verfahren liegt in der aus dem Biegen der Leiterplatten resultierenden bzw. an den Knickstellen vorliegenden Klaffung zwischen den einzelnen Anzeigesegmenten der Anzeigenoberfläche. Zwischen den Anzeigesegmenten entstehen dabei je nach Stärke der Scheibenkrümmung mehr oder weniger große Spalte in der Anzeigenoberfläche. Der optische Eindruck der Anzeige wird hierdurch uneinheitlich. Dies ist insbesondere bei herkömmlichen Scheiben von Bussen oder Bahnen der Fall, bei denen die Krümmung der Scheibe in der Regel nach außen hin zunimmt. Gerade in diesen Fällen wirkt die Anzeige nach außen hin verzerrt bzw. gedehnt.

Der Erfindung liegt deshalb die Aufgabe zugrunde, ein Verfahren zur Herstellung einer hinter einer gekrümmten Scheibe anzuordnenden Punkt-Matrix-Anzeigeeinrichtung anzugeben, das die genannten Nachteile nicht oder nur in geringerem Maße aufweist, insbesondere eine schnelle und einfache Herstellung einer gut abzulesenden Anzeigevorrichtung ermöglicht.

Die Aufgabe wird, ausgehend von einem Verfahren gemäß dem Oberbegriff des Anspruchs 1, durch die im kennzeichnenden Teil des Anspruchs 1 angegebenen Merkmale gelöst.

Die Erfindung schließt die technische Lehre ein, daß sich ein mit besonders einfachen Mitteln zu realisierendes, zeitsparendes Herstellungsverfahren ergibt, wenn die die Anzeige-Elemente zur Anpassung der Punkt-Matrix-Anzeigeeinrichtung an eine gekrümmte Scheibe derart in Richtung der Flächennormalen der Leiterplatte gestuft angeordnet werden, daß wenigstens eine der Hauptkrümmungen der Scheibe nach Art einer Treppe angenähert ist. Die besonders einfache Durchführung des Verfahrens ergibt sich dabei zudem daraus, daß die Elementkörper während der Herstellung der galvanischen Verbindung zwischen den eine zur Stufung ausreichende Länge aufweisenden Anschlußmitteln und der Leiterplatte durch Positioniermittel in ihrem jeweiligen senkrechten Abstand zur Leiterplatte gehalten werden.

Durch die Stufung der Anzeige-Elemente können die Anzeige-Elemente der gesamten Anzeige gegebenenfalls auf einer einzigen Leiterplatte angeordnet werden, die dann in einem einzigen Montageschritt auf einem einfachen, ebenfalls ebenen Halterahmen montiert werden kann, wodurch sich der weitere Herstellungsaufwand für die Anzeigeeinrichtung erheblich reduziert.

Durch die Stufung ist zudem in einfacher Weise sichergestellt, daß unabhängig von der Krümmung der Scheibe, hinter der die Anzeigevorrichtung angeordnet ist, keine Spalte in der Anzeigenoberfläche auftreten, so daß für den Betrachter keine Verzerrung der Anzeige entsteht. Gerade bei der am häufigsten auftretenden Konstellation, in der der Betrachter im wesentlichen frontal auf die Anzeige blickt, entsteht keine Verzerrung, sondern der Betrachter hat den Eindruck, er blicke auf eine gleichmäßige, ebene Anzeige. Zudem treten dank der Stufung keine die Leiterplatte oder die galvanischen Verbindungen zwischen Leiterplatte und Anschlußmitteln beeinträchtigenden Biegebelastungen auf.

Die Positioniermittel, die das jeweilige Anzeige-Element während der Herstellung der galvanischen Verbindung zwischen dessen elektrischen Anschlußmitteln und der Leiterplatte in seinem der Stufung entsprechenden senkrechten Abstand von der Leiterplatte halten, können dabei von den Mitteln gebildet sein, die bereits zum Durchstecken der Anschlußmittel durch die entsprechenden Anschlußbohrungen in der Leiterplatte Anwendung finden, wodurch sich der Herstellungsaufwand noch weiter verringert.

Die Positioniermittel können beispielsweise auch zwischen dem Elementkörper und der Leiterplatte angeordnete Abstandselemente sein, z. B. über die elektrischen Anschlußelemente geführte Röhrchen oder dergleichen, die dort auch nach der Herstellung der galvanischen Verbindung zwischen den Anschlußmitteln und der Leiterplatte verbleiben. Vorzugsweise werden die Positioniermittel aber nach Herstellung der galvanischen Verbindung zwischen den Anschlußmitteln und der Leiterplatte wieder entfernt, wodurch sich der Herstellungsaufwand aufgrund der reduzierten Anzahl zu handhabender Einzelteile weiter verringert.

Die Anzeige-Elemente können, wie bereits oben ausgeführt, als aktive oder passive Bauelemente ausgeführt sein, die jeweils einen Anzeigenpunkt der Punkt-Matrix-Anzeigeeinrichtung bilden. Der Begriff Anzeige-Element soll hier aber auch eine Anzahl solcher aktiver oder passiver Bauelemente umfassen, die zuvor zu einer festen Baugruppe zusammengefaßt oder schon als solche hergestellt wurden.

Bei einer bevorzugten Ausführung des erfindungsgemäßen Verfahrens mit besonders einfachem Verfahrensablauf wird in einem ersten Teilschritt zum Halten des jeweiligen Elementkörpers in seinem jeweiligen senkrechten Abstand zur Leiterplatte ein eine Anschlageinrichtung für das Anzeige-Element bildendes Anschlagelement relativ zur Leiterplatte positioniert und das Anzeige-Element wird durch eine Haltekraft gegen die Anschlageinrichtung gedrückt oder umgekehrt. Das Anzeige-Element wird also zunächst in die korrekte Position gebracht und dann in dieser durch die Positioniermittel festgehalten oder zunächst relativ zu den Positioniermitteln fixiert und dann mit deren Hilfe in die korrekte Position bewegt. In einem zweiten Teilschritt wird anschließend die galvanische Verbindung zwischen den Anschlußmitteln und der Leiterplatte hergestellt. In einem dritten Teilschritt wird schließlich das Anschlagelement nach Herstellung der galvanischen Verbindung entfernt.

Vorzugsweise werden dabei die Anschlußmittel des Anzeige-Elements vor dem ersten Teilschritt in die Bohrungen in der Leiterplatte eingeführt. Das Einfädeln der Anschlußmittel in die Bohrungen der Leiterplatte erfolgt dann also bereits vor dem Positionieren des jeweiligen Elementkörpers im erforderlichen Abstand von der Leiterplatte. Eine aufwendige Bewegungsbahn der Positioniermittel ist damit in einfacher Weise vermieden. Die Anzeige-Elemente können zum einfachen Einfädeln in der Anschlußmittel in die Bohrungen der Leiterplatte beispielsweise durch entsprechende Ausrichtmittel so zusammengefaßt werden, daß die Elementkörper in einer gemeinsamen Ebene liegen und die Anschlußmittel in der korrekten Ausrichtung senkrecht zu dieser Ebene verlaufen. Die Leiterplatte muß dann zum Einfädeln nur noch parallel zu dieser gemeinsamen Ebene der Elementkörper und so ausgerichtet werden, daß die Anschlußmittel mit den entsprechenden Bohrungen der Leiterplatte fluchten, wonach alle Anschlußmittel durch einfaches Verschieben der Leiterplatte senkrecht zur gemeinsamen Ebene der Elementkörper eingefädelt werden können.

Bei bevorzugten, weil einfachen Varianten der Erfindung wird das Anschlagelement vor dem ersten Teilschritt oder während des ersten Teilschrittes als Distanzelement zwischen die Leiterplatte und den Elementkörper eingeführt.

Bei anderen vorteilhaften Ausführungen, die sich durch ihre besonders kurze Herstellungszeit auszeichnen, wird vor dem ersten Teilschritt oder während des ersten Teilschrittes das Anschlagelement auf der der Leiterplatte abgewandten Seite des Anzeige-Elements positioniert und der Elementkörper durch die Haltekraft gegen die Anschlageinrichtung gedrückt. Alternativ oder zusätzlich kann das Anschlagelement auf der dem Anzeige-Element abgewandten Seite der Leiterplatte positioniert und die Enden der Anschlußmittel durch die Haltekraft gegen Anschlageinrichtung gedrückt werden. Bei diesen Varianten kann das Anschlagelement aufgrund seiner Anordnung relativ zu Leiterplatte und Anzeige-Elemente vorteilhafterweise so ausgebildet sein, daß es in seiner Arbeitsstellung die bereits korrekt positionierten Anschlageinrichtungen für mehrere, vorzugsweise alle Anzeige-Elemente bildet, wodurch diese mit einer einzigen Positionierbewegung des Anschlagelements in seine Arbeitsstellung in ihre korrekte Position gebracht werden können.

Bei besonders günstigen Weiterbildungen des erfindungsgemäßen Verfahrens werden die Anzeige-Elemente relativ zur Leiterplatte so angeordnet, daß die Haltekraft im wesentlichen durch das Eigengewicht der Anzeige-Elemente aufgebracht wird. Hierdurch kann eine entsprechende Einrichtung zur Aufbringung der Haltekraft entfallen, wodurch sich das Verfahren weiter vereinfacht. Um ein eventuelles Verkanten oder Verklemmen der Elementkörper oder der elektrischen Anschlußmittel zu verhindern, kann dabei vor dem zweiten Teilschritt, also dem Herstellen der galvanischen Verbindung, ein Rüttelschritt vorgesehen sein, bei dem wenigstens das Anzeige-Element und/oder die Leiterplatte, vorzugsweise die gesamte Anordnung in Vibration versetz wird, um ein korrektes Anliegen der entsprechenden Bestandteile der Anzeige-Elemente an den Anschlageinrichtungen sicherzustellen.

Bei besonders einfachen Varianten des Verfahrens wird die galvanische Verbindung zwischen den Anschlußmitteln und der Leiterplatte als einfache herkömmliche Lötverbindung ausgeführt.

Vorzugsweise werden die auf der den Anzeige-Elementen abgewandten Seite der Leiterplatte überstehenden Abschnitte der Anschlußmittel nach Herstellung der galvanischen Verbindung zwischen den Anschlußmitteln und der Leiterplatte in einem bestimmten Abstand von der Leiterplatte abgetrennt. Der Mindestabstand bestimmt sich dabei in der Regel nach der Art der galvanischen Verbindung. Ist beispielsweise ein Lötpunkt als galvanische Verbindung vorgesehen, so kann knapp oder unmittelbar über dem Lötpunkt abgetrannt werden.

Bei besonders günstigen Varianten des Verfahrens werden mehrere, insbesondere alle, Anzeige-Elemente im wesentlichen gleichzeitig positioniert, wodurch sich die Herstellungszeit weiter verringert.

Vorzugsweise wird ein Anschlagelement mit einer als Anschlagfläche ausgebildeten Anschlageinrichtung verwendet, deren Geometrie im wesentlichen der Geometrie der der Punkt-Matrix-Anzeigeeinrichtung zugewandten Oberfläche der Scheibe entspricht. Dabei kann beispielsweise auch ein dünnwandiges Bauteil als Anschlagelement verwendet werden, das in einem einfachen Formprozeß, beispielsweise durch Warmumformung, von der Scheibe abgeformt wurde. Alternativ kann auch die Scheibe selbst als Anschlagelement verwendet werden.

Andere vorteilhafte Weiterbildungen der Erfindung sind in den Unteransprüchen gekennzeichnet bzw. werden nachstehend zusammen mit der Beschreibung der bevorzugten Ausführung der Erfindung anhand der Figuren näher dargestellt. Es zeigen:
- Figur 1: eine Anordnung zur Ausführung einer bevorzugten Variante des erfindungsgemäßen Verfahrens,
- Figur 2: eine Anordnung zur Ausführung einer weiteren bevorzugten Variante des erfindungsgemäßen Verfahrens.

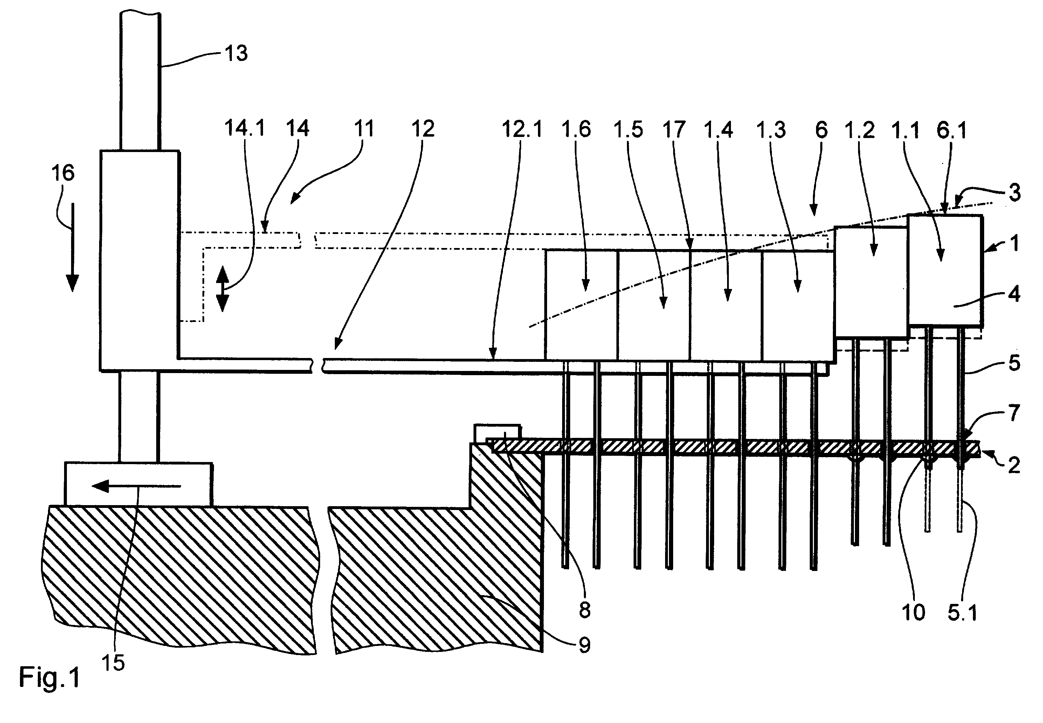

Figur 1 zeigt einen Teilschnitt durch eine Anordnung zur Ausführung des erfindungsgemäßen Verfahrens, bei dem die Anzeige-Elemente 1 auf einer gemeinsamen Leiterplatte 2 derart in Richtung der Flächennormalen der Leiterplatte 2 gestuft angeordnet werden, daß die Krümmung der - durch die strichpunktierte Linie 3 angedeuteten - Scheibe, hinter der die Anzeigeeinrichtung später anzuordnen ist, nach Art einer Treppe angenähert ist.

Die Anzeige-Elemente 1 bestehen aus einem Elementkörper 4 und langgestreckten elektrischen Anschlußmitteln 5. Die Anschlußmittel bestehen im gezeigten Beispiel aus jeweils zwei auf der dem späteren Betrachter der Punkt-Matrix-Anzeigeeinrichtung abgewandten Seite des Elementkörpers 4 angeordneten dünnen Anschlußdrähten 5. Diese verlaufen dabei jeweils senkrecht zu dem von dem Anzeige-Element 1 gebildeten Abschnitt 6.1 der Anzeigenoberfläche 6 und erstrecken sich durch Anschlußbohrungen 7 in der Leiterplatte 2. Die Anschlußdrähte 5 der Anzeige-Elemente 1 weisen dabei jeweils dieselbe Länge auf, die ausreicht, um den infolge der Stufung am weitesten von der Leiterplatte 2 beabstandeten Elementkörper der Anzeigeeinrichtung mit der Leiterplatte 2 zu verbinden.

Zum in Figur 1 festgehaltenen Zeitpunkt im Verfahrensablauf befinden sich die Elementkörper der Anzeige-Elemente 1.1 und 1.2 bereits in ihrem für die Stufung erforderlichen senkrechten Abstand von der Leiterplatte 4, deren Rand über Klemmelemente 8 an einem Montagetisch 9 fixiert ist. Die Anschlußdrähte 5 der Anzeige-Elemente 1.1 und 1.2 sind dabei über Lötpunkte 10 sowohl galvanisch als auch mechanisch mit der Leiterplatte 2 verbunden. Die Anschlußdrähte 5 sind dabei ausreichend starr, um die Elementkörper 4 in ihrer gewünschten Position zur Leiterplatte 2 zu halten.

Zum Positionieren noch nicht mit der Leiterplatte 2 verbundener Anzeige-Elemente - zum in Figur 1 festgehaltenen Zeitpunkt die Anzeige-Elemente 1.3 bis 1.6 - sind Positioniermittel 11 vorgesehen. Diese umfassen ein von einem langgestreckten Bauteil gebildetes Anschlagelement 12, das angetrieben durch einen entsprechenden - in der Figur 1 nicht dargestellten - Antrieb senkrecht zur Ebene der Leiterplatte 2 verschieblich an einem Ständer 13 angeordnet ist. Der Ständer 13 wiederum ist parallel zur Ebene der Leiterplatte 2 in der Schnittebene verschieblich an dem Montagetisch 19 angeordnet, wobei er durch einen entsprechenden - in der Figur 1 ebenfalls nicht dargestellten - Antrieb in Verschieberichtung des Ständers 13 bewegt werden kann.

Das Anschlagelement 12 ist als langgestrecktes Distanzelement zwischen den noch nicht fixierten Anzeige-Elementen 1.3 bis 1.6 und der Leiterplatte 2 angeordnet. Die der Leiterplatte 2 zugewandten Seitenflächen der Anzeige-Elemente 1.3 bis 1.6 liegen auf der ihnen zugewandten Seitenfläche des Anschlagelements 12 auf, die die Anschlageinrichtung 12.1 des Anschlagelements 12 bildet. Das Anschlagelement 12 erstreckt sich dabei zwischen den jeweiligen Anschlußdrähten 5 der Anzeige-Elemente 1.3 bis 1.6 hindurch, d. h. einer der beiden Anschlußdrähte 5 eines jeden der Anzeige-Elemente 1.3 bis 1.6 liegt bezüglich der Schnittebene vor bzw. hinter dem Anschlagelement 12.

Die Leiterplatte 2 ist im gezeigten Beispiel in einer horizontalen Ebene angeordnet, so daß die Haltekraft, die jeweils die darüber angeordneten, noch nicht relativ zur Leiterplatte 2 fixierten Anzeige-Elemente 1.3 bis 1.6 gegen die Anschlageinrichtung 12.1 drückt vom Eigengewicht des jeweiligen Anzeige-Elemente 1.3 bis 1.6 aufgebracht wird.

Ein zusätzliches Element zum Aufbringen der Haltekraft ist im gezeigten Beispiel nicht erforderlich. Es versteht sich jedoch, daß bei anderen Ausführungen ein derartiges Element zum Aufbringen der Haltekraft vorgesehen sein kann. In Figur 1 ist ein solches Element 14, das entlang des Doppelpfeiles 14.1 verschieblich ist und die Anzeige-Elemente 1.3 bis 1.6 gegen die Anschlageinrichtung 12.1 drückt, durch eine strichpunktierte Linie angedeutet.

Der prinzipielle Verfahrensablauf bei der Herstellung der Stufung wird im folgenden anhand der auf den in Figur 1 festgehaltenen Zustand folgenden Verfahrensschritte erläutert. Zunächst werden die beiden Anschlußdrähte 5 des Anzeige-Elements 1.3, das sich im in Figur 1 festgehaltenen Zeitpunkt bereits in seiner korrekten Position befindet, mit der Leiterplatte 2 verlötet. Sobald die Lötverbindung ausreichend ausgehärtet ist, wird der Ständer 13 um die Breite des Anzeige-Elements 1.3, d. h. so weit in Richtung des Pfeiles 15 verfahren, bis sich das Anschlagelement 12 nicht mehr zwischen dem Anzeige-Element 1.3 und der Leiterplatte 2 befindet. Anschließend werden in einem ersten Teilschritt das Anschlagelement 12 und damit auch die restlichen dann noch nicht fixierten Anzeige-Elemente 1.4, 1.5 und 1.6 in Richtung des Pfeiles 16 so weit abgesenkt, bis die Kante 17 des Anzeige-Elements 1.4 auf der Linie 3 liegt und sich das Anzeige-Element 1.4 somit in seiner korrekten Position befindet, in der seine Anschlußdrähte 5 dann in einem zweiten Teilschritt mit der Leiterplatte 2 verlötet werden. In einem dritten Teilschritt wird dann der Ständer 13 um die Breite des Anzeige-Elements 1.4, d. h. so weit in Richtung des Pfeiles 15 verfahren, bis das Anschlagelement 12 aus dem Zwischenraum zwischen dem Anzeige-Element 1.3 und der Leiterplatte entfernt ist. Zur Befestigung der übrigen Anzeige-Elemente 1.5 und 1.6 wird analog verfahren.

Im gezeigten Beispiel werden die Anzeige-Elemente 1 vor der Herstellung der Stufung, d. h. vor der Durchführung des ersten Teilschrittes für das erste zu fixierende Anzeige-Element 1, auf das Anschlagelement 12 gesetzt, das sich dabei zum einen in seiner untersten Verschiebeposition in Richtung des Pfeiles 16 knapp über der Leiterplatte 2 befindet und zum anderen in seiner am weitesten entgegen der Richtung des Pfeiles 15 gelegenen Position befindet. Die Anschlußdrähte 5 der Anzeige-Elemente 1 werden dabei durch die entsprechenden Anschlußbohrungen 7 der Leiterplatte 2 geführt. Anschließend werden die Anzeige-Elemente 1 dann mittels des Anschlagelements 12 in dem ersten Teilschritt für das erste zu fixierende Anzeige-Element 1 gemeinsam angehoben und die Stufung wird analog dem oben beschriebenen Ablauf durchgeführt.

Nachdem alle Anzeige-Elemente 1 auf der Leiterplatte fixiert wurden, werden die über die Leiterplatte 2 nach unten hinausragenden Abschnitte 5.1 der Anschlußdrähte 5 knapp unterhalb des jeweiligen Lötpunktes 10 abgetrennt, wie dies in Figur 1 durch die gestrichelt gezeichneten Abschnitte der Anschlußdrähte 5 des Anzeige-Elements 1.1 an gedeutet ist. Es versteht sich jedoch, daß das Abtrennen aber auch bereits unmittelbar nach dem Verlöten des jeweiligen Anschlußdrahtes 5 erfolgen kann.

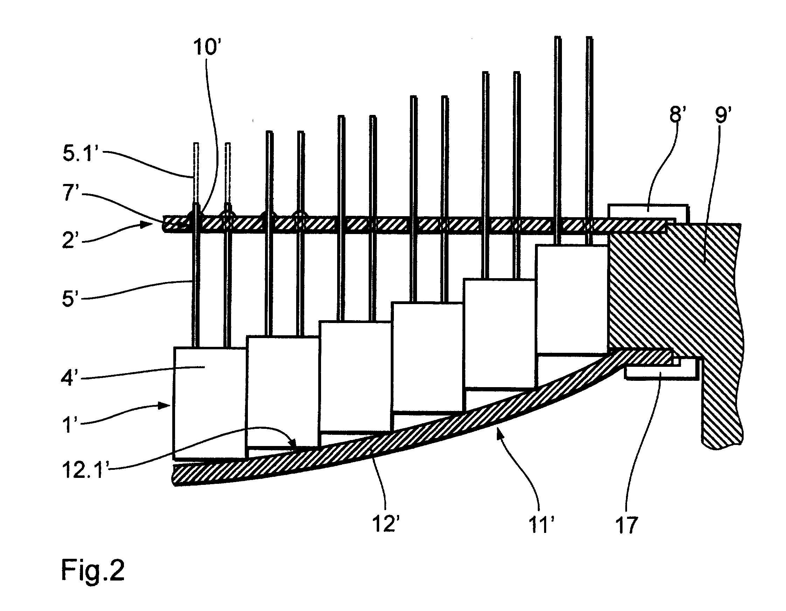

Figur 2 zeigt einen Teilschnitt durch eine Anordnung zur Ausführung einer weiteren Variante des erfindungsgemäßen Verfahrens, bei der die Anzeige-Elemente 1' auf einer gemeinsamen Leiterplatte 2' gestuft angeordnet werden. Die Leiterplatte 2' ist dabei zum in Figur 2 festgehaltenen Zeitpunkt im Verfahrensablauf als in einer horizontalen Ebene angeordnet und über Klemmelemente 8' an einem Montagetisch 9 fixiert. Die Elementkörper 4' der Anzeige-Elemente 1' sind unterhalb der Leiterplatte 2', wobei sich die Anschlußdrähte 5' der Anzeige-Elemente 1' durch die entsprechenden Anschlußbohrungen 7' in der Leiterplatte 2' hindurch erstrecken. Auf der der Leiterplatte 2' abgewandten Seite der Anzeige-Elemente 1' ist eine Positioniereinrichtung 11' angeordnet, die von einem dünnwandigen Anschlagelement 12' gebildet ist, das mittels Klemmelementen 17 am Montagetisch 9' fixiert ist.

Die Anzeige-Elemente 1' werden durch ihr Eigengewicht gegen die ihnen zugewandte Anschlagfläche 12.1' des Anschlagelements 12' gedrückt, die die Anschlageinrichtung bildet. Die Geometrie der Anschlagfläche 12.1' entspricht dabei der Geometrie der der Punkt-Matrix-Anzeigeeinrichtung später zugewandten Oberfläche der Scheibe in dem Bereich, in dem die Punkt-Matrix-Anzeigeeinrichtung später hinter der Scheibe anzuordnen ist. Im gezeigten Beispiel ist das Anschlagelement 12' ein dünnwandiges Kunststoffbauteil, das im Bereich der Anschlagfläche 12.1' durch einen Warmumformungsprozeß von der entsprechenden Scheibe, hinter der die Punkt-Matrix-Anzeigeeinrichtung später anzuordnen ist, abgeformt wurde.

Im in Figur 2 festgehaltenen Zeitpunkt befinden sich die Elementkörper 4' der Anzeige-Elemente 1' in ihrer korrekten Position zur Leiterplatte 2' und werden dort im weiteren Verfahrensablauf relativ zur Leiterplatte 2' fixiert, indem ihre Anschlußdrähte 5' mittels Lötpunkten 10' mit der Leiterplatte 2' verbunden werden. Anschließend werden die über die Leiterplatte 2' hinausragenden Endabschnitte 5.1' der Anschlußdrähte 5' abgetrennt, wie dies schon zu Figur 1 beschrieben wurde, und die Leiterplatte 2' mit den darauf gestuft angeordneten Anzeige-Elemente 1' wird zur weiteren Herstellung der Punkt-Matrix-Anzeigeeinrichtung nach Lösen der Klemmelemente 8' vom Montagetisch 9' entfernt.

Im gezeigten Beispiel werden die Anzeige-Elemente 1' vor dem in Figur 2 festgehaltenen Zeitpunkt so von oben auf die dabei um eine horizontale Achse um 180° gedrehte Leiterplatte gesetzt, daß die Anschlußdrähte 5' durch die Anschlußbohrungen der Leiterplatte 2' verlaufen und die Elementkörper 4' auf der Leiterplatte 2' aufliegen. Anschließend wird die Leiterplatte 2' mit den darauf befindlichen Anzeige-Elementen 1' von unten auf den ebenfalls um eine horizontale Achse um 180° gedrehten Montagetisch 9' gesetzt und an diesem mittels der Klemmelemente 8' fixiert. Im Anschluß daran wird der Montagetisch 9' dann um eine horizontale Achse um 180° in die in Figur 2 dargestellte Position gedreht, wodurch die Anzeige-Elemente 1' infolge ihres Eigengewichtes in die in Figur 2 dargestellte Position gleiten. Um sicherzustellen, daß sich sämtliche Anzeige-Elemente 1' in ihrer korrekten Position befinden, wird der Montagetisch 9' anschließend noch für einen gewissen Zeitraum in Vibration versetzt. Erst im Anschluß daran werden die Anzeige-Elemente 1' wie oben beschrieben fixiert.

Die Erfindung beschränkt sich in ihrer Ausführung nicht auf die vorstehend angegebenen bevorzugten Ausführungsbeispiele. Vielmehr ist eine Anzahl von Varianten denkbar, welche von der dargestellten Lösung auch bei grundsätzlich anders gearteten Ausführungen Gebrauch macht.

## Patentansprüche

1. Verfahren zur Herstellung einer hinter einer gekrümmten Scheibe anzuordnenden Punkt-Matrix-Anzeigeeinrichtung aus die Punkte der Anzeige-Matrix bildenden Anzeige-Elementen (1; 1'), die einen Elementkörper (4; 4') und jeweils auf dessen dem Betrachter abgewandter Seite angeordnete dünne, langgestreckte, im wesentlichen senkrecht zum von ihnen gebildeten Abschnitt (6.1) der Anzeigenoberfläche (6) verlaufende elektrische Anschlußmittel (5; 5') aufweisen, bei dem die Anzeige-Elemente (1; 1') auf wenigstens einer ebenen Leiterplatte (2; 2') angeordnet werden, wobei ihre Anschlußmittel (5; 5') durch entsprechende Bohrungen (7; 7') in der Leiterplatte (2; 2') geführt und anschließend galvanisch mit der Leiterplatte (2; 2') verbunden werden,
**dadurch gekennzeichnet**,
daß die Anzeige-Elemente (1; 1') zur Anpassung der Punkt-Matrix-Anzeigeeinrichtung an eine gekrümmte Scheibe derart in Richtung der Flächennormalen der Leiterplatte (2; 2') gestuft angeordnet werden, daß wenigstens eine der Hauptkrümmungen der Scheibe nach Art einer Treppe angenähert ist, wobei die Elementkörper (4; 4') wenigstens während der Herstellung der galvanischen Verbindung (10; 10') zwischen den eine zur Stufung ausreichende Länge aufweisenden Anschlußmitteln (5; 5') und der Leiterplatte (2; 2') durch Positioniermittel (11; 11') in ihrem jeweiligen senkrechten Abstand zur Leiterplatte (2; 2') gehalten werden.

2. Verfahren nach Anspruch 1, **dadurch gekennzeichnet**, daß die Positioniermittel (11; 11') nach Herstellung der galvanischen Verbindung (10; 10') zwischen den Anschlußmitteln (5; 5') und der Leiterplatte (2; 2') wieder entfernt werden.

3. Verfahren nach Anspruch 1 oder 2, **dadurch gekennzeichnet**, daß in einem ersten Teilschritt zum Halten des jeweiligen Elementkörpers (4; 4') in seinem jeweiligen senkrechten Abstand zur Leiterplatte (2; 2') ein eine Anschlageinrichtung (12; 12') für das Anzeige-Element (1; 1') bildendes Anschlagelement (12.1; 12.1') relativ zur Leiterplatte (2; 2') positioniert wird und das Anzeige-Element (1; 1') durch eine Haltekraft gegen die Anschlageinrichtung (12; 12') gedrückt wird oder umgekehrt, in einem zweiten Teilschritt die galvanische Verbindung (10; 10') zwischen den Anschlußmitteln (5; 5') und der Leiterplatte (2; 2') hergestellt wird und in einem dritten Teilschritt die Anschlageinrichtung (12; 12') nach Herstellung der galvanischen Verbindung entfernt wird.

4. Verfahren nach Anspruch 3, **dadurch gekennzeichnet**, daß die Anschlußmittel (5; 5') des Anzeige-Elements (1; 1') vor dem ersten Teilschritt in die Bohrungen (7; 7') in der Leiterplatte (2; 2') eingeführt werden.

5. Verfahren nach Anspruch 3 oder 4, **dadurch gekennzeichnet**, daß das Anschlagelement (12') vor dem ersten Teilschritt oder während des ersten Teilschrittes als Distanzelement zwischen die Leiterplatte (2) und den Elementkörper (4) eingeführt wird.

6. Verfahren nach Anspruch 3 oder 4, **dadurch gekennzeichnet**, daß vor dem ersten Teilschritt oder während des ersten Teilschrittes das Anschlagelement (12') auf der der Leiterplatte (2') abgewandten Seite des Anzeige-Elements (1') positioniert wird und der Elementkörper (4') durch die Haltekraft gegen die Anschlageinrichtung (12.1') gedrückt wird und/oder das Anschlagelement (12') auf der dem Anzeige-Element (1') abgewandten Seite der Leiterplatte (2') positioniert wird und die Enden der Anschlußmittel (5') durch die Haltekraft gegen Anschlageinrichtung (12.1') gedrückt werden.

7. Verfahren nach einem der vorhergehenden Ansprüche, **dadurch gekennzeichnet**, daß die Anzeige-Elemente (1; 1') relativ zur Leiterplatte (2; 2') so angeordnet werden, daß die Haltekraft im wesentlichen durch das Eigengewicht der Anzeige-Elemente (1; 1') aufgebracht wird.

8. Verfahren nach Anspruch 7, **dadurch gekennzeichnet**, daß zur Sicherstellung des korrekten Anliegens der Anzeige-Elemente (1') an den Anschlageinrichtungen (12.1') vor dem zweiten Teilschritt ein Rüttelschritt vorgesehen ist, bei dem wenigstens die Anzeige-Elemente (1') und/oder die Leiterplatte (2') in Vibration versetz werden bzw. wird.

9. Verfahren nach einem der vorhergehenden Ansprüche, **dadurch gekennzeichnet**, daß die galvanische Verbindung zwischen den Anschlußmitteln (5; 5') und der Leiterplatte (2; 2') als Lötverbindung (10; 10') ausgeführt wird.

10. Verfahren nach einem der vorhergehenden Ansprüche, **dadurch gekennzeichnet**, daß die auf der den Anzeige-Elementen (1; 1') abgewandten Seite der Leiterplatte (2; 2') überstehenden Abschnitte (5.1; 5.1') der Anschlußmittel (5; 5') nach Herstellung der galvanischen Verbindung (10; 10') zwischen den Anschlußmitteln (5; 5') und der Leiterplatte (2; 2') in einer bestimmten Höhe über der Leiterplatte (2; 2') abgetrennt werden.

11. Verfahren nach einem der vorhergehenden Ansprüche, **dadurch gekennzeichnet**, daß mehrere, insbesondere alle, Anzeige-Elemente (1; 1') im wesentlichen gleichzeitig positioniert werden.

12. Verfahren nach einem der Ansprüche 6 bis 11, **dadurch gekennzeichnet**, daß ein Anschlagelement (12') mit einer als Anschlagfläche ausgebildeten Anschlageinrichtung (12.1') verwendet wird, deren Geometrie im wesentlichen der Geometrie der der Punkt-Matrix-Anzeigeeinrichtung zugewandten Oberfläche der Scheibe entspricht oder die Scheibe selbst als Anschlagelement (12') verwendet wird.
